(19) Europäisches Patentamt
European Patent Office
Office européen des brevets

(11) EP 1 538 681 A2

(12) EUROPEAN PATENT APPLICATION

(43) Date of publication:
08.06.2005 Bulletin 2005/23

(51) Int Cl.7: H01L 33/00, H01L 23/29

(21) Application number: 04028768.2

(22) Date of filing: 03.12.2004

(84) Designated Contracting States:
AT BE BG CH CY CZ DE DK EE ES FI FR GB GR HU IE IS IT LI LT LU MC NL PL PT RO SE SI SK TR
Designated Extension States:
AL BA HR LV MK YU

(30) Priority: 04.12.2003 JP 2003406400

(71) Applicant: NITTO DENKO CORPORATION
Osaka (JP)

(72) Inventors:
- Suehiro, Ichirou
Ibaraki-shi Osaka (JP)
- Hotta, Yuji
Ibaraki-shi Osaka (JP)
- Sadayori, Naoki
Ibaraki-shi Osaka (JP)
- Kamada, Takashi
Ibaraki-shi Osaka (JP)

(74) Representative: Grünecker, Kinkeldey,
Stockmair & Schwanhäusser Anwaltssozietät
Maximilianstrasse 58
80538 München (DE)

# (54) Process for producing optical semiconductor device

(57) The invention provides a process for producing an optical semiconductor device, which comprises: (1) forming a resin layer on one or more optical semiconductor elements each mounted on a conductor; and (2) press-molding the resin layer formed in step (1).

FIG. 3

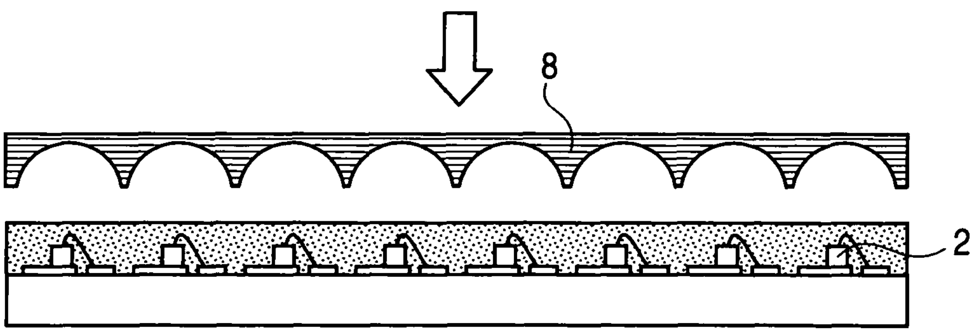


EP 1 538 681 A2

## Description

### FIELD OF THE INVENTION

The present invention relates to a process for producing an optical semiconductor device.

### BACKGROUND OF THE INVENTION

An optical semiconductor device is known which includes an optical semiconductor element encapsulated with two or more resin layers disposed in order of their decreasing refractive index from the optical-semiconductor element side toward the outermost layer so as to have an improved efficiency of light takeout (see patent document 1).

Patent Document 1: JP 10-65220 A (claim 1)

The first encapsulating resin to be in direct contact with optical semiconductor elements has hitherto been formed by dipping or potting. However, resin encapsulation by dipping or potting has drawbacks that the operation of dropping a liquid resin onto each of optical semiconductor elements in a predetermined amount is troublesome and that unevenness of the encapsulated elements in encapsulant shape is apt to result in uneven light emission.

### SUMMARY OF THE INVENTION

An object of the invention is to provide a process for producing an optical semiconductor device with which the resin encapsulation of one or more optical semiconductor elements can be easily and evenly conducted.
Other objects and effects of the invention will become apparent from the following description.
The invention relates to a process for producing an optical semiconductor device, which comprises:

(1) forming a resin layer on one or more optical semiconductor elements each mounted on a conductor; and
(2) press-molding the resin layer formed in step (1).

According to the invention, the resin encapsulation of optical semiconductor elements can be easily and evenly conducted and a high-quality optical semiconductor device having evenness in the efficiency of light takeout can be obtained.

### BRIEF DESCRIPTION OF THE DRAWINGS

Fig. 1 illustrates one embodiment of step (1) of the invention in which a resin layer is formed on optical semiconductor elements.
Fig. 2 illustrates another embodiment of step (1) of the invention in which a resin layer is formed on optical semiconductor elements.
Fig. 3 illustrates one embodiment of step (2) of the invention in which a resin layer is press-molded with a stamper.
Fig 4 is a sectional view illustrating one embodiment of light-emitting diode arrays obtained by the invention.

The reference numerals used in the drawings denote the followings, respectively.

1: resin
2: optical semiconductor element
3: substrate
4: laminator
5: casting die
6: wire
7: conductor
8: stamper
9: LED array
10: LED chip
11: first resin layer
12: second resin layer

DETAILED DESCRIPTION OF THE INVENTION

The process of the invention for producing an optical semiconductor device comprises:

(1) forming a resin layer on one or more optical semiconductor elements each mounted on a conductor; and
(2) press-molding the resin layer formed in step (1).

In step (1), the optical semiconductor elements are not particularly limited as long as they are ones for ordinary use in optical semiconductor devices. Examples thereof include gallium nitride (GaN; refractive index, 2.5), gallium-phosphorus (GaP; refractive index, 2.9), and gallium-arsenic (GaAs; refractive index, 3.5). GaN is preferred of these because it emits a blue light and a white LED can be produced therefrom using a phosphor therewith.

The conductor on which each optical semiconductor element is mounted is not particularly limited as long as it is one for ordinary use in optical semiconductor devices. The conductor to be used may be a lead frame having a predetermined shape, or may be a conductor which has been made to have a predetermined shape by etching.

The substrate on which one or more optical semiconductor elements and conductors are to be mounted also is not particularly limited. However, it is preferred in the invention that the device comprises one substrate and, mounted thereon, two or more conductors and two or more optical semiconductor elements, from the standpoint of exerting the effect of the invention more remarkably.

The refractive index of the resin for constituting the resin layer in step (1) (This resin may hereinafter sometimes be referred to as "first resin") is preferably 1.6 or higher, more preferably 1.7 to 2.1, from the standpoint of heightening the efficiency of light takeout from the optical semiconductor element.

Examples of the resin for encapsulating the optical semiconductor elements include polyethersulfones, polyimides, aromatic polyamides, polycarbodiimides, and epoxy resins.

Preferred of these for use as the resin constituting the resin layer in step (1) are polycarbodiimides from the standpoint of ease of processing at low temperatures and low pressures. More preferred is a polycarbodiimide represented by formula (1):

$$R^1-N=C=N\left(R-N=C=N\right)_n R^1 \qquad (1)$$

(wherein R represents a diisocyanate residue, $R^1$ represents

a monoisocyanate residue, and n is an integer of 1-100).

In the invention, the polycarbodiimide represented by formula (1) is obtained by subjecting one or more diisocyanates to a condensation reaction and blocking the terminals of the resulting polymer with a monoisocyanate.

In formula (1), R represents a residue of the diisocyanate used as a starting material and $R^1$ represents a residue of the monoisocyanate used as another starting material. Symbol n is an integer of 1 to 100.

The diisocyanate and monoisocyanate to be used as starting materials may be either aromatic or aliphatic. The diisocyanate and the monoisocyanate each may consist of one or more aromatic isocyanates alone or one or more aliphatic isocyanates alone, or may comprise a combination of an aromatic isocyanate and an aliphatic isocyanate. From the standpoint of obtaining a polycarbodiimide having a higher refractive index, it is preferred to use aromatic isocyanates in the invention. Namely, it is preferred that at least either of the diisocyanate and the monoisocyanate comprises an aromatic isocyanate or consist of one or more aromatic isocyanates, or that each of the diisocyanate and the monoisocyanate consists of one or more aromatic isocyanates. More preferred is the case in which the diisocyanate comprises a combination of an aliphatic isocyanate and an aromatic isocyanate and the monoisocyanate consists of one or more aromatic isocyanates. Especially preferred is the case in which the diisocyanate and the monoisocyanate each consist of one or more aromatic isocyanates.

Examples of diisocyanates usable in the invention include hexamethylene diisocyanate, dodecamethylene diisocyanate, 2,2,4-trimethylhexamethylene diisocyanate, 4,4'-dichlorohexylmethane diisocyanate, xylylene diisocyanate, tetramethylxylylene diisocyanate, isophorone diisocyanate, cyclohexyl diisocyanate, lysine diisocyanate, methylcyclohexane 2,4'-diisocyanate, 4,4'-diphenylmethane diisocyanate, 4,4'-diphenyl ether diisocyanate, 2,6-tolylene diisocyanate, 2,4-tolylene diisocyanate, naphthalene diisocyanate, 1-methoxyphenyl 2,4-diisocyanate, 3,3'-dimethoxy-4,4'-diphenylmethane diisocyanate, 4,4'-diphenyl ether diisocyanate, 3,3'-dimethyl-4,4'-diphenyl ether diisocyanate,

2,2-bis[4-(4-isocyanatophenoxy)phenyl]-hexafluoropropane, and 2,2-bis[4-(4-isocyanatophenoxy)-phenyl]propane.

From the standpoints of enabling the polycarbodiimide to have a high refractive index and of ease of the control thereof, it is preferred to use, among those diisocyanates, at least one member selected from the group consisting of tolylene diisocyanate, 4,4'-diphenylmethane diisocyanate, naphthalene diisocyanate, hexamethylene diisocyanate, and dodecamethylene diisocyanate. More preferred is naphthalene diisocyanate.

Those diisocyanates can be used singly or as a mixture of two or more thereof. From the standpoint of heat resistance, however, it is preferred to use a mixture of two or three diisocyanates.

The one or more diisocyanates to be used as a starting material preferably comprise one or more aromatic diisocyanates in an amount of preferably 10% by mole or larger (upper limit, 100% by mole) based on all diisocyanates. These diisocyanates desirably are ones enumerated above as preferred examples.

Examples of monoisocyanates usable in the invention include cyclohexyl isocyanate, phenyl isocyanate, p-nitrophenyl isocyanate, p- and m-tolyl isocyanates, p-formylphenyl isocyanate, p-isopropylphenyl isocyanate, and 1-naphthyl isocyanate.

Preferred monoisocyanates are aromatic monoisocyanates because aromatic monoisocyanates do not react with each other and the terminal blocking of a polycarbodiimide with such monoisocyanates proceeds efficiently. It is more preferred to use 1-naphthyl isocyanate.

Those monoisocyanates can be used singly or as a mixture of two or more thereof.

The amount of the monoisocyanate to be used for terminal blocking is preferably in the range of from 1 to 10 mol per 100 mol of the diisocyanate ingredient to be used, from the standpoint of storage stability.

The polycarbodiimide production according to the invention can be conducted by converting one or more diisocyanates as a starting material to a carbodiimide through condensation reaction in a predetermined solvent in the presence of a catalyst for carbodiimide formation and blocking the terminals of the resultant carbodiimide polymer with a monoisocyanate.

The diisocyanate condensation reaction is conducted at a temperature of generally from 0 to 150°C, preferably from 10 to 120°C.

In the case where an aliphatic diisocyanate and an aromatic diisocyanate are used in combination as starting-material diisocyanates, it is preferred to react the diisocyanates at a low temperature. The reaction temperature is preferably from 0 to 50°C, more preferably from 10 to 40°C. Use of a reaction temperature in this range is preferred because the condensation of the aliphatic diisocyanate with the aromatic diisocyanate proceeds sufficiently.

In the case where an excess aromatic diisocyanate present in the reaction mixture is desired to be further reacted with the polycarbodiimide formed from an aliphatic diisocyanate and an aromatic diisocyanate, the reaction temperature is preferably from 40 to 150°C, more preferably from 50 to 120°C. As long as the reaction temperature is within this range, any desired solvent can be used to smoothly conduct the reaction. The reaction temperature range is therefore preferred.

The diisocyanate concentration in the reaction mixture is preferably from 5 to 80% by weight. As long as the diisocyanate concentration is within this range, carbodiimide formation proceeds sufficiently and reaction control is easy. The diisocyanate concentration range is therefore preferred.

Terminal blocking with a monoisocyanate can be accomplished by adding the monoisocyanate to the reaction mixture in an initial, middle, or final stage of carbodiimide formation from the diisocyanate(s) or throughout the carbodiimide formation. The monoisocyanate is preferably an aromatic monoisocyanate.

As the catalyst for carbodiimide formation, any of known phosphorus compound catalysts can be advantageously used. Examples thereof include phospholene oxides such as 1-phenyl-2-phospholene 1-oxide, 3-methyl-2-phospholene 1-oxide, 1-ethyl-2-phospholene 1-oxide, 3-methyl-1-phenyl-2-phospholene 2-oxide, and the 3-phospholene isomers of these.

The solvent (organic solvent) to be used for producing the polycarbodiimide is a known one. Examples thereof include halogenated hydrocarbons such as tetrachloroethylene, 1,2-dichloroethane, and chloroform, ketone solvents such as acetone, methyl ethyl ketone, methyl isobutyl ketone, and cyclohexanone, cyclic ether solvents such as tetrahydrofuran and dioxane, and aromatic hydrocarbon solvents such as toluene and xylene. These solvents can be used singly or as a mixture of two or more thereof. These solvents are used also for dissolving the obtained polycarbodiimide.

The end point of the reaction can be ascertained by infrared spectroscopy (IR analysis) from the occurrence of absorption attributable to the carbodiimide structure (N=C=N) (2,140 $cm^{-1}$) and the disappearance of absorption attributable to the isocyanates (2,280 $cm^{-1}$).

After completion of the carbodiimide-forming reaction, a polycarbodiimide is obtained usually in the form of a solution. However, the solution obtained may be poured into a poor solvent such as methanol, ethanol, isopropyl alcohol, or hexane to precipitate the polycarbodiimide and remove the unreacted monomers and the catalyst.

In preparing a solution of the polycarbodiimide which has been recovered as a precipitate, the precipitate is washed and dried in a predetermined manner and then dissolved again in an organic solvent. By performing this

operation, the polycarbodiimide solution can have improved storage stability.

In the case where the polycarbodiimide solution contains by-products, the solution may be purified, for example, by adsorptively removing the by-products with an appropriate adsorbent. Examples of the adsorbent include alumina gel, silica gel, activated carbon, zeolites, activated magnesium oxide, activated bauxite, Fuller's earth, activated clay, and molecular sieve carbon. These adsorbents can be used singly or in combination of two or more thereof.

By the method described above, the polycarbodiimide according to the invention is obtained. From the standpoint of enabling the polycarbodiimide constituting the resin layer in step (1) to have a higher refractive index, the polycarbodiimide preferably is one in which the backbone structure is constituted of aromatic and aliphatic diisocyanates and the terminals have been blocked with an aromatic monoisocyanate. More preferred is one in which the backbone structure is constituted of one or more aromatic diisocyanates and the terminals have been blocked with an aromatic monoisocyanate.

Specifically, the polycarbodiimide preferably is one in which 10% by mole or more (upper limit, 100% by mole) of the diisocyanate residues represented by R in formula (1) are residues of one or more aromatic diisocyanates and the monoisocyanate residues represented by $R^1$ in formula (1) are residues of one or more aromatic monoisocyanates. The diisocyanate residues preferably are residues of at least one member selected from the group consisting of tolylene diisocyanate, 4,4'-diphenylmethane diisocyanate, naphthalene diisocyanate, hexamethylene diisocyanate, and dodecamethylene diisocyanate, and more preferably are naphthalene diisocyanate residues. The aromatic monoisocyanate residues preferably are 1-naphthyl isocyanate residues.

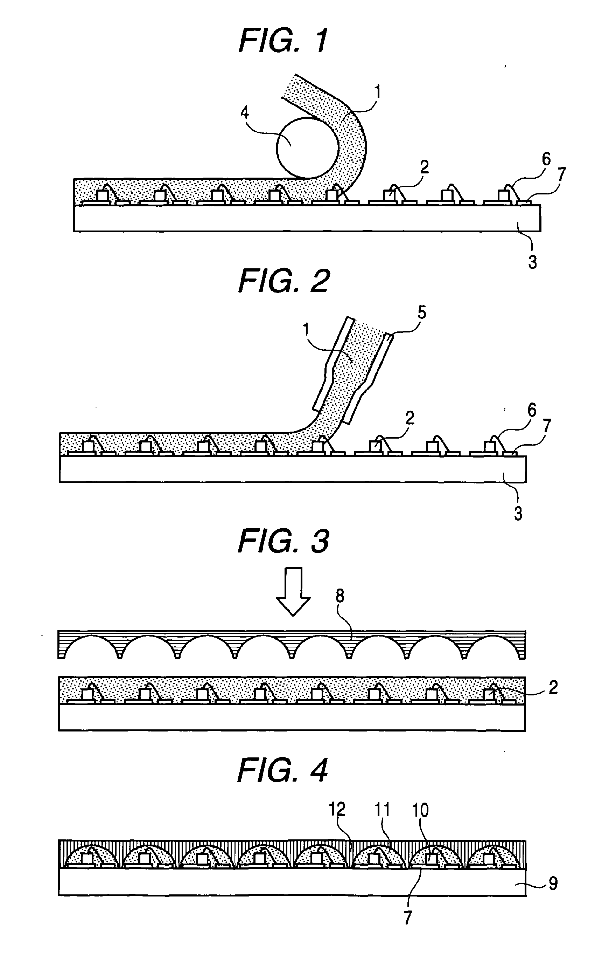

Examples of methods for carrying out the step of forming a resin layer comprising the first resin on one or more optical semiconductor elements include: a method in which a sheet-form resin 1 is laminated by means of, e.g., a laminator 4 onto a substrate 3 having optical semiconductor elements 2 mounted thereon, as shown in Fig. 1; and a method in which a resin 1 is applied by, e.g., casting die 5 to a substrate 3 having optical semiconductor elements 2 mounted thereon and is then cured, as shown in Fig. 2. In each of Figs. 1 and 2, the optical semiconductor elements 2 each have been connected to a conductor 7 by a wire 6 in accordance with an ordinary technique.

In the method shown in Fig. 1, the sheet-form resin is obtained, for example, by dissolving a resin in a solvent, forming the resultant resin solution into a film having an appropriate thickness by a technique such as, e.g., casting, spin coating, or roll coating, and then drying the film at such a temperature that the solvent can be removed without causing a curing reaction to proceed. The temperature at which the resin solution which has been formed into a film is to be dried cannot be unconditionally determined because it varies depending on the kinds of the resin and solvent. However, the temperature is preferably 20 to 350°C, more preferably 50 to 200°C. The thickness of the sheet-form resin obtained through drying with heating is preferably about 150 to 400 µm when the height of the optical semiconductor elements and molding with a stamper are taken into account. It is also possible to use two or more such resin sheets superposed on each other.

In the case where the sheet-from resin is melted and laminated to a substrate by thermal press bonding using a laminator or the like, it is preferred that the resin be heated to preferably 70 to 250°C, more preferably 100 to 200°C, and pressed at preferably 0.1 to 10 MPa, more preferably 0.5 to 5 MPa. When a laminator is used, the revolution speed thereof is preferably 100 to 2,000 rpm, more preferably 500 to 1,000 rpm.

In the method shown in Fig. 2, die conditions for the casting include a heating temperature of preferably 30 to 80°C, more preferably 50 to 60°C, and a line speed of preferably 0.5 to 8 m/min. The temperature for drying after application is preferably 20 to 350°C, more preferably 100 to 200°C, and the drying period is preferably 10 to 60 minutes.

Step (1) as illustrated above is followed by step (2). The feature of the invention mainly resides in step (2). By press-molding the resin layer formed in step (1), the optical semiconductor elements can be easily encapsulated with an even resin layer, and an optical semiconductor device having evenness in the efficiency of light takeout can be obtained.

The press molding of the resin layer can be conducted with a stamper or the like. In the invention, the stamper to be used can be, for example, one obtained by forming a polyimide sheet or polycarbonate sheet into a predetermined die by laser processing or one obtained by plating such a die as a master (original) with a metal, e.g., nickel.

The press molding of the resin layer with a stamper can be conducted, for example, in the manner shown in Fig. 3. The stamper 8 is aligned so that a resin layer having recesses or protrusions can be formed over the optical semiconductor elements 2. This assemblage is inserted into the space between a heated pressing plate and another heated pressing plate and then heated/pressed, whereby the resin layer formed in step (1) can be thermally cured and molded. Use of the stamper enables many optical semiconductor elements to be encapsulated at a time with a resin layer having an even shape.

Examples of conditions for the heating/pressing include a temperature for the heating of preferably 70 to 250°C, more preferably 100 to 200°C, a pressure for the pressing of preferably 0.1 to 10 MPa, more preferably 0.5 to 5 MPa, and a period of this heating/pressing of preferably from 5 seconds to 3 minutes, more preferably from 10 seconds to 1 minute.

By molding the resin layer on the optical semiconductor elements into a shape having recesses or protrusions,

the light regulation and efficiency of light takeout by the resultant lenses can be improved.

It is preferred in the invention that the following step (3) be further conducted after step (2):

(3) forming, on the resin layer press-molded in step (2) (hereinafter referred to as "first resin layer"), a second resin layer comprising a second resin having a lower refractive index than the first resin constituting the first resin layer.

The second resin is not particularly limited as long as it has been selected while taking account of its refractive index. Specifically, the second resin is selected so that it has a lower refractive index than that of the first resin. However, the specific refractive index difference for the first resin and second resin {[(refractive index of first resin) - (refractive index of second resin)]/(refractive index of first resin) x 100} is preferably 5 to 35% from the standpoint of heightening the efficiency of light takeout at the resin layer interface.

Examples of the second resin include the same resins as those enumerated above as examples of the first resin. However, epoxy resins are preferred from the standpoints of ease of molding and low cost.

The first resin layer and second resin layer may suitably contain a light-scattering filler, e.g., silica, and additives, e.g., a fluorescent agent.

The second resin layer can be formed by a method appropriately selected from known ones such as, e.g., injection molding, casting, transfer molding, dipping, and potting with a disperser.

One or more resin layers may be further formed on the outer side of the second resin layer according to need. In this case, it is preferred that the resulting plural resin layers be disposed in order of their decreasing refractive index of the resin toward the outermost resin layer.

By press-molding a resin layer on optical semiconductor elements with a stamper as in the invention, the optical semiconductor elements can be easily and evenly encapsulated with the resin, and a high-quality optical semiconductor device having evenness in the efficiency of light takeout can be obtained. Consequently, the optical semiconductor device to be produced by the invention preferably is an optical semiconductor device comprising a substrate and a plurality of optical semiconductor elements mounted thereon, in particular, a light-emitting diode array. An example of light-emitting diode arrays obtained by the invention is shown in Fig. 4. In Fig. 4, the LED chips 10 and conductors 7 on the LED array 9 have been encapsulated with a first resin layer 11 press-molded with a stamper and the first resin layer 11 has been encapsulated with a second resin layer 12.

EXAMPLES

The present invention will be illustrated in greater detail with reference to the following Examples, but the invention should not be construed as being limited thereto.

In the following Examples, all synthesis reactions were conducted in a nitrogen stream. IR analysis was made with FT/IR-230 (manufactured by Nippon Bunko K.K.).

<u>Polycarbodiimide Production Example</u>

Into a 500-mL four-necked flask equipped with a stirrer, dropping funnel, reflux condenser, and thermometer were introduced 29.89 g (171.6 mmol) of tolylene diisocyanate (isomer mixture; T-80, manufactured by Mitsui-Takeda Chemical), 94.48 g (377.52 mmol) of 4,4'-diphenylmethane diisocyanate, 64.92 g (308.88 mmol) of naphthalene diisocyanate, and 184.59 g of toluene. These ingredients were mixed together.

Thereto were added 8.71 g (51.48 mmol) of 1-naphthyl isocyanate and 0.82 g (4.29 mmol) of 3-methyl-1-phenyl-2-phospholene 2-oxide. The resultant mixture was heated to 100°C with stirring and held for 2 hours.

The progress of reactions was ascertained by IR analysis. Specifically, the decrease in the amount of absorption by N-C-O stretching vibration attributable to the isocyanates (2,280 $cm^{-1}$) and the increase in the amount of absorption by N=C=N stretching vibration attributable to carbodiimide (2,140 $cm^{-1}$) were followed. After the end point of the reactions was ascertained by IR analysis, the reaction mixture was cooled to room temperature. Thus, a polycarbodiimide solution (to be used in Comparative Example 1) was obtained. In this polycarbodiimide, 100% by mole of the diisocyanate residues were aromatic diisocyanate residues. This polycarbodiimide was represented by general formula (1) described above wherein n ranged from 15 to 77.

Subsequently, the polycarbodiimide solution was applied to a separator (thickness, 50 μm) [manufactured by Toray Industries, Inc.] consisting of a poly(ethylene terephthalate) film treated with a release agent (fluorinated silicone). This coating was heated at 130°C for 1 minute and then at 150°C for 1 minute. Thereafter, the separator was removed to obtain a temporarily cured sheet-form polycarbodiimide (thickness, 50 μm).

The sheet-form polycarbodiimide obtained was cured in a 150°C curing oven. This cured resin was examined for refractive index with a multi-wavelength Abbe's refractometer (DR-M4, manufactured by ATAGO) at a wavelength of 589 nm and a temperature of 25°C. The refractive index of the cured resin was found to be 1.748.

EXAMPLE 1

Four sheets of the temporarily cured sheet-form polycarbodiimide obtained in the above-described Production Example were stacked up to produce a sheet having dimensions of 50 mm x 30 mm and a thickness of 200 μm. This sheet was laminated to a substrate having dimensions of 50 mm x 30 mm and having 7 x 18 LED chips comprising GaN mounted thereon (2.5 x 2.2 mm pitch). This laminating was conducted with a laminator at a revolution speed of 500 rpm, roll temperature of 100°C, and roll pressure of 0.5 MPa. Thus, a first resin layer was formed.

Subsequently, a stamper (made of polyimide) having 0.74-mm-diameter recesses with a depth of 0.17 mm disposed in 4×4 arrangement with a pitch of 2.5×2.2 mm was superposed on the first resin layer to press-mold the first resin layer at 200°C and 1.5 MPa for 1 minute.

An epoxy resin (NT-8006, manufactured by Nitto Denko; refractive index, 1.560) was then superposed as a low-refractive-index resin layer (second resin layer) and cured at 120°C for 5 hours. Thus, a light-emitting diode array of the surface mounting type was obtained.

The thickness of the high-refractive-index resin layer as measured in the projecting parts was 175 μm, and the total resin thickness was 300 μm. Since the refractive index of the high-refractive-index resin layer was 1.748, the difference in refractive index between this resin layer and the low-refractive-index resin layer was 0.188.

In the light-emitting diode array obtained, the quantity of the light emitted by each light-emitting diode (absolute energy) as measured from the front was 0.13 $\mu W/cm^2/nm$ on the average, and the standard deviation thereof was 0.025 $\mu W/cm^2/nm$.

COMPARATIVE EXAMPLE 1

A light-emitting diode array was produced in the same manner as in Example 1, except that the polycarbodiimide solution was dropped onto each LED chip to form a first resin layer.

In the light-emitting diode array obtained, the quantity of the light emitted by each light-emitting diode as measured from the front was 0.08 $\mu W/cm^2/nm$ on the average, and the standard deviation thereof was 0.019 $\mu W/cm^2/nm$.

Those results show that since Example 1 does not necessitate the dropping of a predetermined amount of a resin onto each LED chip as conducted in Comparative Example 1, the production process of Example 1 is simple and the diode array obtained thereby has reduced unevenness in the efficiency of light takeout from each LED chip.

The optical semiconductor device produced by the invention is suitable for use as, e.g., a surface light source for personal computers, cell phones, etc.

While the present invention has been described in detail and with reference to specific embodiments thereof, it will be apparent to one skilled in the art that various changes and modifications can be made therein without departing from the spirit and scope thereof.

The present application is based on Japanese patent application No. 2003-406400 filed December 4, 2003, the contents thereof being herein incorporated by reference.

## Claims

**1.** A process for producing an optical semiconductor device, which comprises:

(1) forming a resin layer on one or more optical semiconductor elements each mounted on a conductor; and
(2) press-molding the resin layer formed in step (1).

**2.** The process of claim 1, wherein step (2) is carried out with a stamper.

**3.** The process of claim 1 or 2, further comprising, after step (2):

(3) forming, on the resin layer press-molded in step (2), a second resin layer comprising a second resin having a lower refractive index than the resin constituting the press-molded resin layer.

**4.** The process of any one of claims 1 to 3, wherein the resin layer formed in step (1) comprises a polycarbodiimide represented by formula (1):

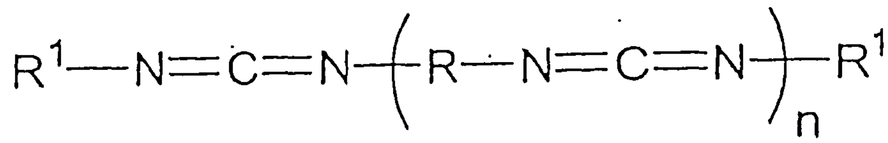

(1)

(wherein R represents a diisocyanate residue, $R^1$ represents a monoisocyanate residue, and n is an integer of 1-100).

**5.** The process of any one of claims 1 to 4, wherein the optical semiconductor device is a light-emitting diode array.

FIG. 1

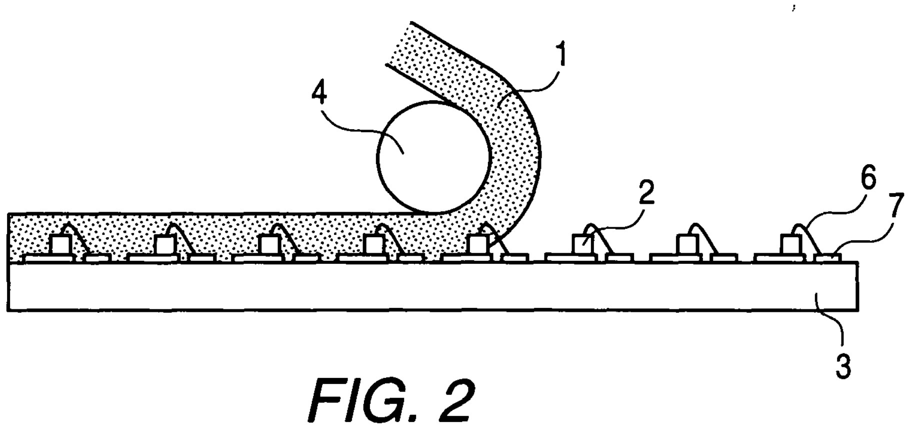


FIG. 2

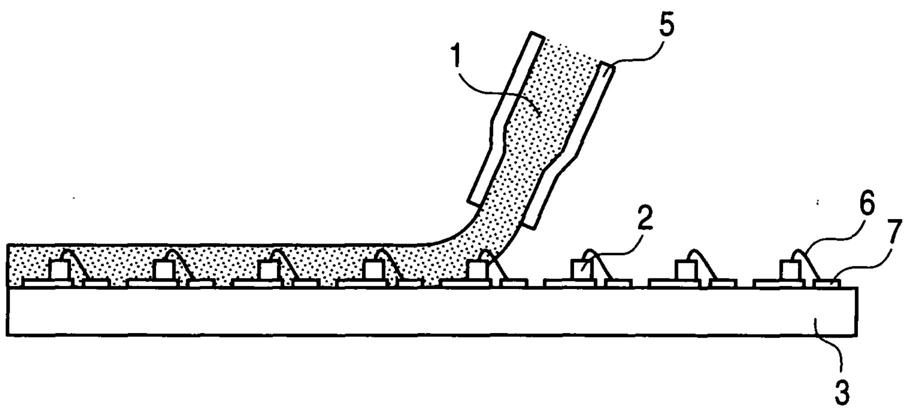


FIG. 3

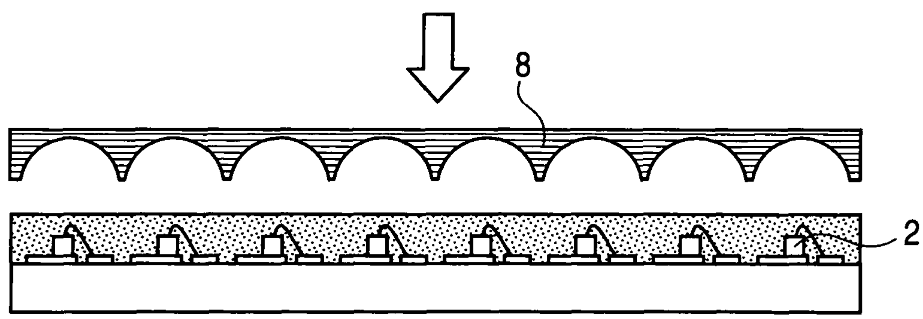


FIG. 4